# EUROPÄISCHE PATENTANMELDUNG

(11) **EP 4 328 549 A1**
(43) Veröffentlichungstag der Anmeldung: **28.02.2024**
(21) Anmeldenummer: 23192321.0
(22) Anmeldetag: 21.08.2023
(51) Int. Cl.: G01F 1/58, G01F 25/10, G01F 1/60

(54) **TESTVORRICHTUNG FÜR EIN MODULARES MAGNETISCH-INDUKTIVES DURCHFLUSSMESSGERÄT, TESTVERFAHREN FÜR EINE SOLCHE TESTVORRICHTUNG, TESTVORRICHTUNG FÜR EIN MONOLITHISCHES MAGNETISCH-INDUKTIVES DURCHFLUSSMESSGERÄT UND TESTVERFAHREN FÜR EINE SOLCHE TESTVORRICHTUNG**

(30) Priorität: 24.08.2022 DE 102022121407
(71) Anmelder: Krohne Messtechnik GmbH, 47058 Duisburg (DE)
(72) Erfinder: Gerding, Michael, 44805 Bochum (DE); Kaluza, Olaf, 45699 Herten (DE); Florin, Wilhelm, 47198 Duisburg (DE)
(74) Vertreter: Gesthuysen Patentanwälte

(57) **Zusammenfassung**

Dargestellt und beschrieben ist eine Testvorrichtung (21) für ein modulares magnetisch-induktives Durchflussmessgerät (1).

Die Erfindung löst die Aufgabe, eine Testvorrichtung (21) für einen trockenen Funktionstest anzugeben, welche ohne eine Messung eines Stroms durch eine Spule (3) des modularen magnetisch-induktiven Durchflussmessgeräts (1) auskommt.

Die Aufgabe ist durch eine Testvorrichtung (21) gelöst, die eine Teststeuerung (22) und ein Testmessmodul (23) für eine Messmodulaufnahme (5) des modularen magnetisch-induktiven Durchflussmessgeräts (1) aufweist. Das Testmessmodul (23) weist eine Halterung (24) mit einem Magnetfeldsensor (25) auf. In der Teststeuerung (22) ist mindestens ein Sollwert mindestens einer Größe des Magnetfelds (14) abgespeichert. Die Teststeuerung (22) ist ausgebildet, bei eingesetztem Testmessmodul (23) in die Messmodulaufnahme (5) unter Verwendung des Magnetfeldsensors (25) mindestens einen Istwerts der mindestens einen Größe des Magnetfelds (14) zu messen und eine Abweichung des mindestens einen Istwerts von dem mindestens einen Sollwert zu bestimmen und die Abweichung anzuzeigen.

## Beschreibung

Die Erfindung betrifft mehrere Gegenstände.

Ein Gegenstand der Erfindung ist eine Testvorrichtung für ein modulares magnetisch-induktives Durchflussmessgerät.

Das zu testende modulare magnetisch-induktive Durchflussmessgerät weist eine Spule, eine Steuerung und eine Messmodulaufnahme für ein Messmodul auf. Die Messmodulaufnahme weist einen ersten Anschluss und einen zweiten Anschluss auf. Der erste Anschluss und der zweite Anschluss sind jeweils über eine Messleitung mit der Steuerung verbunden.

Das Messmodul weist einen ersten Anschluss, einen zweiten Anschluss und ein Messrohr mit zwei Messelektroden auf.

Durch ein Einsetzen des Messmoduls in die Messmodulaufnahme sind zum einen die ersten Anschlüsse und zum anderen die zweiten Anschlüsse jeweils miteinander verbindbar. Wenn das Messmodul in die Messmodulaufnahme eingesetzt ist, dann sind also zum einen der erste Anschluss des Messmoduls und der erste Anschluss der Messmodulaufnahme und zum anderen der zweite Anschluss des Messmoduls und der zweite Anschluss der Messmodulaufnahme elektrisch miteinander verbunden.

Bei eingesetztem Messmodul ist die Spule zur Erzeugung eines Magnetfelds in einem Medium im Messrohr ausgebildet, sind die Messelektroden zum abgreifen einer durch ein Strömen des Mediums im Magnetfeld erzeugten Messspannung im Medium ausgebildet und ist die Steuerung zur Bestimmung eines Durchflusses des Mediums unter Verwendung der über die ersten und zweiten Anschlüsse und die Messleitungen übertragenen Messspannung ausgebildet. Auch ist die Steuerung zur Steuerung der Spule ausgebildet.

Wenn das Messmodul in die Messmodulaufnahme eingesetzt und das magnetisch-induktive Durchflussmessgerät im Betrieb ist, dabei wird insbesondere ein Medium durch das Messrohr geströmt, gilt also das Folgende: Die Spule ist zur Erzeugung des Magnetfelds in dem Medium im Messrohr ausgebildet. Die Messelektroden sind zum Abgreifen der durch das Strömen des Mediums im Magnetfeld erzeugten Messspannung im Medium ausgebildet. Die Steuerung ist zur Bestimmung des Durchflusses des Mediums unter Verwendung der über die ersten und zweiten Anschlüsse und die Messleitungen übertragenen Messspannung ausgebildet. Demnach ist eine der beiden Messelektroden mit dem ersten Anschluss des Messmoduls verbunden, ist der erste Anschluss des Messmoduls mit dem ersten Anschluss der Messmodulaufnahme verbunden und ist der erste Anschluss der Messmodulaufnahme mit der Steuerung über eine der beiden Messleitungen verbunden. Entsprechend ist die andere der beiden Messelektroden mit dem zweiten Anschluss des Messmoduls verbunden, ist der zweite Anschluss des Messmoduls mit dem zweiten Anschluss der Messmodulaufnahme verbunden und ist der zweite Anschluss der Messmodulaufnahme mit der Steuerung über die andere der beiden Messleitungen verbunden. Auf diese Weise liegt die zwischen den Messelektroden abgegriffene Spannung auch an der Steuerung an.

Ein weiterer Gegenstand der Erfindung ist ein Testverfahren für eine Testvorrichtung für ein solches modulares magnetisch-induktives Durchflussmessgerät.

Ein weiterer Gegenstand ist eine Testvorrichtung für ein monolithisches magnetisch-induktives Durchflussmessgerät.

Das zu testende monolithische magnetisch-induktive Durchflussmessgerät weist eine Spule, eine Steuerung und ein Messrohr mit zwei Messelektroden auf. Jede der Messelektroden ist über jeweils eine Messleitung mit der Steuerung verbunden.

Die Spule ist zur Erzeugung eines Magnetfelds in einem Medium im Messrohr ausgebildet. Die Messelektroden sind zum Abgreifen einer durch ein Strömen des Mediums im Magnetfeld erzeugten Messspannung im Medium ausgebildet. Die Steuerung ist zur Bestimmung eines Durchflusses des Mediums unter Verwendung der über die Messleitungen übertragenen Messspannung ausgebildet. Die Spule ist außerhalb des Messrohrs angeordnet. Das von der Spule im Betrieb erzeugte Magnetfeld erstreckt sich deshalb nicht nur auf ein Medium im Messrohr, sondern auch auf einen Außenraum um das Messrohr.

Ein weiterer Gegenstand der Erfindung ist ein Testverfahren für eine Testvorrichtung für ein solches monolithisches magnetisch-induktives Durchflussmessgerät.

Sowohl das modulare als auch das monolithische magnetisch-induktive Durchflussmessgerät sind magnetisch-induktive Durchflussmessgeräte. Das modulare magnetisch-induktive Durchflussmessgerät unterscheidet sich von dem monolithischen magnetisch-induktiven Durchflussmessgerät insbesondere durch einen modularen Aufbau. Dieser ist durch die Messmodulaufname und das Messmodul umgesetzt. Modulare magnetisch-induktive Durchflussmessgeräte kommen insbesondere in Anwendungen zum Einsatz, bei denen aufeinanderfolgend der Durchfluss von verschiedenen Medien zu bestimmen ist und die Medien nicht miteinander in Kontakt treten dürfen. Dafür muss bei einem modularen magnetisch-induktiven Durchflussmessgerät nur das Messmodul ausgetauscht werden. Solche Anwendungen, zu diesen gehören insbesondere Anwendungen, bei welchen eine Querkontamination zu vermeiden ist, gibt es z. B. in der Medizin und dort z. B. bei Durchflussmessungen vom Blut verschiedener Personen.

Ein magnetisch-induktives Durchflussmessgerät wird grundsätzlich kalibriert, sodass es einen Durchfluss eines Mediums durch das Messrohr mit einer bestimmten Genauigkeit bestimmt. Mit Durchfluss ist eine Durchflussrate gemeint und diese bezieht sich auf ein Volumen oder eine Masse. Ein wesentlicher Schritt einer solchen Kalibrierung ist, dass ein bekanntes Medium mit einer bekannten Geschwindigkeit durch das Messrohr geströmt wird, ein Durchfluss unter Verwendung der Geschwindigkeit und einer Geometrie des Messrohrs bestimmt und einer von der Steuerung gemessenen Messspannung zugeordnet wird. Dieser wesentliche Schritt wird für gewöhnlich mehrfach und/oder für verschiedene Durchflüsse durchgeführt, um eine Genauigkeit der Kalibrierung zu erhöhen. Demnach ist für eine Kalibrierung eine Vorrichtung erforderlich, in welche ein magnetisch-induktives Durchflussmessgerät zur Kalibrierung montiert wird und welche bekannte Durchflüsse eines Mediums erzeugt. Folglich ist eine Kalibrierung eines magnetisch-induktiven Durchflussmessgeräts mit einem erheblichen Aufwand verbunden.

Eine Kalibrierung umfasst inhärent auch einen Funktionstest der Steuerung. Es besteht ein Bedarf, einen Funktionstest der Steuerung unabhängig von einer aufwendigen Kalibrierung durchführen zu können. Zu solchen Funktionstests gehören trockene Funktionstests. Bei einem trockenen Funktionstest ist das Messrohr frei von einem Medium.

Aus dem Stand der Technik bekannt ist eine Testvorrichtung, welche aus einem Strom durch die Spule des zu testenden magnetisch-induktiven Durchflussmessgerät ein Maß für eine Stärke des Magnetfelds bestimmt, aus diesem Maß und einem durch die Testvorrichtung vorgegebenen Durchfluss eine Testspannung erzeugt und diese zwischen den Messelektroden einspeist. Das magnetisch-induktive Durchflussmessgerät bestimmt dann einen Durchfluss aus der als Messspannung dienenden Testspannung, welcher mit dem an der Testvorrichtung eingestellten Durchfluss vergleichbar ist. Das stellt einen Funktionstest der Steuerung des magnetisch-induktiven Durchflussmessgeräts dar.

Ein Nachteil dieser Testvorrichtung ist, dass der Strom durch die Spule gemessen werden muss, um ein Maß für die Stärke des Magnetfelds zu erhalten. Das Messen des Stroms kann auf einfache Weise erfolgen, wenn eine entsprechende Schnittstelle am magnetisch-induktiven Durchflussmessgerät vorhanden ist. Falls eine solche nicht vorhanden ist, steigt der Aufwand für die Messung des Stroms an.

Eine Aufgabe der vorliegenden Erfindung ist die Angabe einer Testvorrichtung und eines Testverfahrens für einen trockenen Funktionstest, welche bzw. welches ohne eine Messung des Stroms durch die Spule auskommt.

Die Aufgabe ist durch eine Testvorrichtung für ein modulares magnetisch-induktives Durchflussmessgerät mit den Merkmalen von Anspruch 1 gelöst. Die Testvorrichtung ist dadurch gekennzeichnet, dass sie eine Teststeuerung und ein Testmessmodul für die Messmodulaufnahme aufweist. Das Testmessmodul weist eine Halterung mit einem Magnetfeldsensor auf. In der Teststeuerung ist mindestens ein Sollwert mindestens einer Größe des Magnetfelds abgespeichert. Die Teststeuerung ist ausgebildet, bei eingesetztem Testmessmodul unter Verwendung des Magnetfeldsensors mindestens einen Istwert der mindestens einen Größe des Magnetfelds zu messen. Weiter ist die Teststeuerung ausgebildet, eine Abweichung des mindestens einen Istwerts von dem mindestens einen Sollwert zu bestimmen und die Abweichung anzuzeigen. Zum Anzeigen der Abweichung weist die Teststeuerung vorzugsweise eine Anzeige auf.

Das Testmessmodul ist wie auch das Messmodul kompatibel mit der Messmodulaufnahme. Die Teststeuerung ist zum Beispiel im Testmessmodul angeordnet. Das Testmessmodul und die Halterung sind derart ausgebildet, sodass der Magnetfeldsensor bei in die Messmodulaufnahme eingesetztem Testmessmodul dort angeordnet ist, wo im Betrieb des magnetisch-induktiven Durchflussmessgeräts das von der Spule erzeugte Magnetfeld ist. Der Magnetfeldsensor ist also im Magnetfeld angeordnet. Vorzugsweise ist der Magnetfeldsensor dort angeordnet, wo bei dem in der Messmodulaufnahme angeordneten Messmodul ein Medium durch das Messrohr strömt. Somit misst der Magnetfeldsensor dort eine Größe des Magnetfelds, wo im Betrieb des magnetisch-induktiven Durchflussmessgeräts ein Medium durch das von der Spule erzeugte Magnetfeld strömt und die Messspannung in das Medium induziert wird.

Die erfindungsgemäße Testvorrichtung ermöglicht eine Messung einer Grö-ße des Magnetfelds, ohne dass ein Strom durch die Spule bestimmt werden muss. Die Bestimmung und die Anzeige der Abweichung stellt einen trockenen Funktionstest des modularen magnetisch-induktiven Durchflussmessgeräts dar.

In einer Ausgestaltung des modularen magnetisch-induktiven Durchflussmessgeräts weist das Testmessmodul einen ersten Anschluss und einen zweiten Anschluss auf und sind der erste Anschluss und der zweite Anschluss jeweils mit der Teststeuerung verbunden. Weiter sind durch ein Einsetzen des Testmessmoduls in die Messmodulaufnahme zum einen die ersten Anschlüsse und zum anderen die zweiten Anschlüsse jeweils miteinander verbindbar. Die Teststeuerung ist ferner zum Einspeisen einer Testspannung zwischen dem ersten Anschluss und dem zweiten Anschluss ausgebildet. Erste und zweite Anschlüsse sind im Rahmen der Erfindung immer elektrische Anschlüsse und z. B. als Steckverbinder ausgeführt.

Wenn das Testmessmodul in die Messmodulaufnahme eingesetzt ist, dann sind also zum einen der erste Anschluss des Testmessmoduls und der erste Anschluss der Messmodulaufnahme und zum anderen der zweite Anschluss des Testmessmoduls und der zweite Anschluss der Messmodulaufnahme elektrisch miteinander verbunden. Wenn das Testmessmodul im Betrieb die Testspannung zwischen dem ersten und dem zweiten Anschluss einspeist, dann fällt diese über dem ersten und dem zweiten Anschluss ab. Diese Testspannung wird über die ersten und zweiten Anschlüsse und über die Messleitungen zur Steuerung geleitet, wo die Testspannung als Messspannung anliegt.

In einer weiteren Ausgestaltung ist das Testmessmodul werkzeuglos und beschädigungsfrei manuell einsetzbar in die, entnehmbar aus der und befestigbar in der Modulaufnahme. Das Testmessmodul und die Modulaufnahme sind dementsprechend ausgebildet. Vorzugsweise gilt das auch für das Messmodul. Diese Ausgestaltung vereinfacht die Durchführung des trockenen Funktionstests.

In einer weiteren Ausgestaltung ist die Halterung ein Messrohr. Vorzugsweise handelt es sich bei diesem Messrohr um das Messrohr eines Messmoduls. Das vereinfacht die Herstellung des Testmessmoduls, da gleiche Komponenten verwendet werden können. In einer Alternative dazu basiert das Testmessmodul auf dem Messmodul, es ist also ein modifiziertes Messmodul.

Weiter ist die Aufgabe auch durch eine Testvorrichtung für ein monolithisches magnetisch-induktives Durchflussmessgerät mit den Merkmalen von Anspruch 5 gelöst. Die Testvorrichtung ist dadurch gekennzeichnet, dass sie eine Teststeuerung und einen Magnetfeldsensor aufweist. Die Teststeuerung ist zur Anordnung des Magnetfeldsensors im Magnetfeld ausgebildet, vorzugsweise im Messrohr. In der Teststeuerung ist mindestens ein Sollwert mindestens einer Größe des Magnetfelds abgespeichert. Der Magnetfeldsensor ist zum Messen mindestens eines Istwerts der mindestens einen Größe des Magnetfelds und die Teststeuerung zum Bestimmen einer Abweichung des mindestens einen Istwert von dem mindestens einen Sollwert und zur Anzeige der Abweichung ausgebildet. Die Teststeuerung ist demnach derart ausgebildet, dass der Magnetfeldsensor im Magnetfeld im Außenraum um das Messrohr oder im Magnetfeld im Messrohr anordenbar ist.

In einer Ausgestaltung ist die Teststeuerung mit den Messelektroden reversibel und beschädigungsfrei verbindbar. Dazu weist die Teststeuerung zum Beispiel Testleitungen auf, welche unmittelbar mit den Messelektroden am Messrohr verbindbar sind. Die Messelektroden sind über die Messleitungen mit der Steuerung verbunden. Oftmals sind die Messelektroden und die Messleitungen über Steckverbinder miteinander verbunden. Dann bietet es sich an, die Teststeuerung mit den Messelektroden über diese Steckverbinder zu verbinden.

In einer weiteren Ausgestaltung des magnetisch-induktiven Durchflussmessgeräts, sei es das modulare oder das monolithische magnetisch-induktive Durchflussmessgerät, ist die mindestens eine Größe des Magnetfelds eine Stärke und/oder eine Frequenz und/oder eine Einschwingzeit des Magnetfelds. Dementsprechend ist der Magnetfeldsensor ausgebildet, die Stärke und/oder die Frequenz des Magnetfelds zu messen.

In einer Weiterbildung von Ausgestaltungen, die die Einspeisung einer Testspannung umfassen, ist die Größe eine Stärke des Magnetfelds. Weiter ist die Teststeuerung dann ausgebildet, einen Istwert der Stärke des Magnetfelds zu messen, zu einem Sollwert eines Durchflusses eines Mediums unter Verwendung des Istwerts der Stärke des Magnetfelds einen Sollwert für die Messspannung zu bestimmen, die Testspannung mit dem Sollwert zu erzeugen, einen von der Steuerung bestimmten Istwert des Durchflusses aus der Steuerung auszulesen, eine Abweichung des Istwerts vom Sollwert zu bestimmen und die Abweichung anzuzeigen. Die Stärke des Magnetfelds besteht für gewöhnlich aus einem Betrag und einer Polarität. Der Sollwert des Durchflusses ist der Teststeuerung zum Beispiel vorgegeben oder in dieser abgespeichert.

Im Betrieb des magnetisch-induktiven Durchflussmessgeräts und der Testvorrichtung wird das folgende ausgeführt:
Von der Steuerung wird unter Verwendung der Spule das Magnetfeld erzeugt. Das Magnetfeld ist zum Beispiel ein Wechselmagnetfeld. Von der Teststeuerung wird dann ein Istwert der Stärke des Magnetfelds gemessen, ein Sollwert für die Messspannung unter Verwendung des Istwerts der Stärke des Magnetfelds zu einem Sollwert eines Durchflusses bestimmt, die Testspannung mit dem Sollwert erzeugt und zwischen dem ersten und zweiten Anschluss eingespeist. Von der Steuerung wird diese Testspannung als Messspannung gemessen und unter Verwendung der Messspannung ein Istwert des Durchflusses des Mediums bestimmt. Von der Teststeuerung wird dann der von der Steuerung bestimmte Istwert des Durchflusses aus der Steuerung ausgelesen, eine Abweichung des Istwerts von dem Sollwert bestimmt und die Abweichung angezeigt.

In einer Weiterbildung der zuvor beschriebenen Ausgestaltung weist die Steuerung als Komponenten die Messleitungen, einen Verstärker zur Verstärkung der Messspannung, einen Analog-Digital-Umsetzer zur Digitalisierung der verstärkten Messspannung, eine Recheneinheit zur Bestimmung des Durchflusses des Mediums unter Verwendung der digitalisierten Messspannung und eine Schnittstelle zur Ausgabe des bestimmten Durchflusses auf. Weiter ist die Teststeuerung zur Prüfung von zumindest einer der Komponenten unter Verwendung der zuvor bestimmten Abweichung ausgebildet. Die Teststeuerung ist z. B. ausgebildet, den Istwert des Durchflusses an der Schnittstelle auszulesen.

In einer weiteren Ausgestaltung ist der mindestens eine Sollwert ein zuvor gemessener Istwert, sodass die Abweichung ein Maß für eine Reproduzierbarkeit ist. Vorzugsweise werden die mit dieser Ausgestaltung einhergehenden Schritte zur Erzeugung der Sollwerte und der Istwerte mehrfach ausgeführt, wodurch die Reproduzierbarkeit mit höherer Zuverlässigkeit bestimmt ist.

In einer weiteren Ausgestaltung weist die Testvorrichtung einen Energiespeicher auf und ist die Testvorrichtung zur Versorgung mit Energie aus dem Energiespeicher ausgebildet.

In einer weiteren Ausgestaltung ist die Testvorrichtung zur Versorgung durch ein magnetisch-induktives Durchflussmessgerät ausgebildet.

In einer weiteren Ausgestaltung ist der Magnetfeldsensor ein Hall-Sensor.

Die Aufgabe ist auch durch ein Testverfahren für eine Testvorrichtung für das zuvor beschriebene modulare magnetisch-induktive Durchflussmessgerät mit den Merkmalen von Anspruch 14 gelöst. Das Testverfahren wird von einer Testvorrichtung ausgeführt, die eine Teststeuerung und ein Testmessmodul für die Messmodulaufnahme aufweist. Das Testmessmodul weist eine Halterung mit einem Magnetfeldsensor auf.

Gemäß dem Verfahren wird von der Teststeuerung mindestens ein Sollwert mindestens einer Größe des Magnetfelds abgespeichert und wird das Testmessmodul in die Messmodulaufnahme des zu testenden modularen magnetisch-induktiven Durchflussmessgeräts eingesetzt. Dann wird von der Spule das Magnetfeld erzeugt und wird von der Teststeuerung unter Verwendung des Magnetfeldsensors mindestens ein Istwert der mindestens einen Größe des Magnetfelds gemessen. Weiter wird von der Teststeuerung eine Abweichung des mindestens einen Istwerts von dem mindestens einen Sollwert bestimmt und angezeigt.

In einer Ausgestaltung des Testverfahrens ist dessen Testvorrichtung wie in einer der zuvor beschriebenen Ausgestaltungen und Weiterbildungen der Testvorrichtung für das modulare magnetisch-induktiven Durchflussmessgeräts ausgebildet.

Die Aufgabe ist auch durch ein Testverfahren für eine Testvorrichtung für das zuvor beschriebene monolithische magnetisch-induktive Durchflussmessgerät mit den Merkmalen von Anspruch 16 gelöst. Das Testverfahren wird von ein einer Testvorrichtung ausgeführt, die eine Teststeuerung und einen Magnetfeldsensor aufweist. Die Testvorrichtung ist zur Anordnung des Magnetfeldsensors im Magnetfeld ausgebildet, vorzugsweise im Messrohr.

Gemäß dem Verfahren wird von der Teststeuerung mindestens ein Sollwert mindestens einer Größe des Magnetfelds abgespeichert. Dann wird von der Spule das Magnetfeld erzeugt und wird von der Teststeuerung unter Verwendung des Magnetfeldsensors mindestens ein Istwert der mindestens einen Größe des Magnetfelds gemessen. Weiter wird von der Teststeuerung eine Abweichung des mindestens einen Istwerts von dem mindestens einen Sollwert bestimmt und angezeigt.

In einer Ausgestaltung des Testverfahrens ist dessen Testvorrichtung wie in einer der zuvor beschriebenen Ausgestaltungen und Weiterbildungen der Testvorrichtung für das monolithische magnetisch-induktive Durchflussmessgerät ausgebildet.

In einer Ausgestaltung des Testverfahrens wird ein Trocken-Kalibrierverfahren unter Verwendung der Abweichung ausgeführt. Trocken-Kalibrierverfahren unterscheiden sich von der zuvor erwähnten Kalibrierung dadurch, dass das Messrohr frei von einem Medium ist.

Im Übrigen gelten die Ausführungen zu einer Testvorrichtung oder einem Testverfahren entsprechend für die anderen Testvorrichtungen und Testverfahren.

Im Einzelnen ist eine Vielzahl an Möglichkeiten gegeben, die Gegenstände der Erfindung auszugestalten und weiterzubilden. Dazu wird verwiesen zum einen auf die den unabhängigen Ansprüchen nachgeordneten Ansprüche und zum anderen auf die nachfolgende Beschreibung von bevorzugten Ausführungsbeispielen in Verbindung mit der Zeichnung. In der Zeichnung zeigt
- Figur 1: ein Ausführungsbeispiel eines modularen magnetisch-induktiven Durchflussmessgeräts in einer perspektivischen Seitenansicht,
- Figur 2: das modulare magnetisch-induktive Durchflussmessgerät in einer geschnittenen Seitenansicht,
- Figur 3: ein Ausführungsbeispiel eines Messmoduls für das modulare magnetisch-induktive Durchflussmessgerät in einer perspektivischen Seitenansicht,
- Figur 4: das Messmodul in einer geschnittenen Seitenansicht,
- Figur 5: ein Ausführungsbeispiel einer Testvorrichtung für das modulare magnetisch-induktive Durchflussmessgerät in einer perspektivischen Seitenansicht,
- Figur 6: die Testvorrichtung in einer geschnittenen perspektivischen Seitenansicht
- Figur 7: einen Ablaufplan eines Ausführungsbeispiels eines Testverfahrens für die Testvorrichtung,
- Figur 8: ein Ausführungsbeispiel einer Testvorrichtung für ein monolithisches magnetisch-induktives Durchflussmessgerät mit einem solchen in einer Vorderansicht,
- Figur 9: einen Ablaufplan eines Ausführungsbeispiels eines Testverfahrens für die Testvorrichtung,
- Figur 10: ein Blockschaltbild der Steuerungen des modularen und des monolithischen magnetisch-induktiven Durchflussmessgeräts.

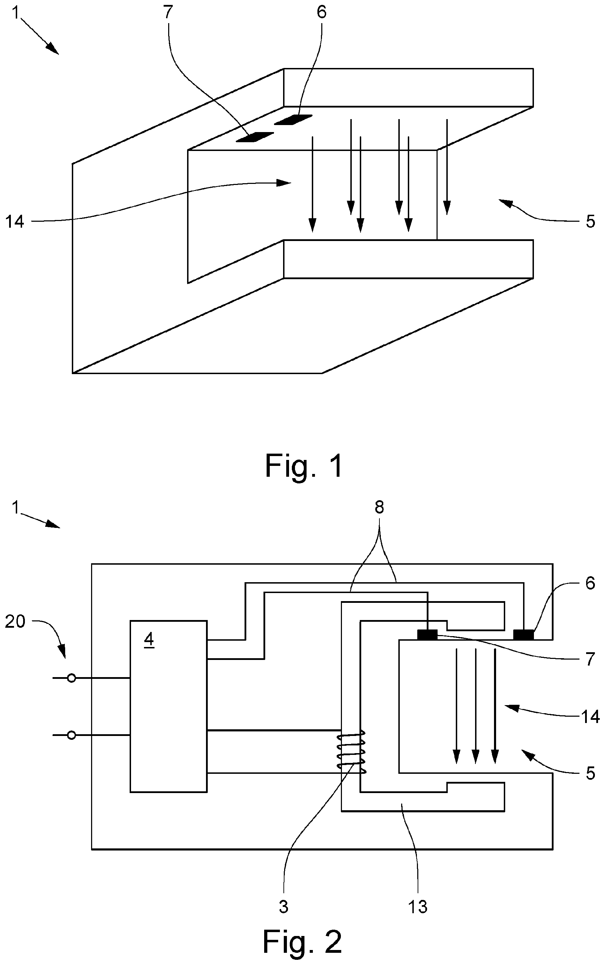

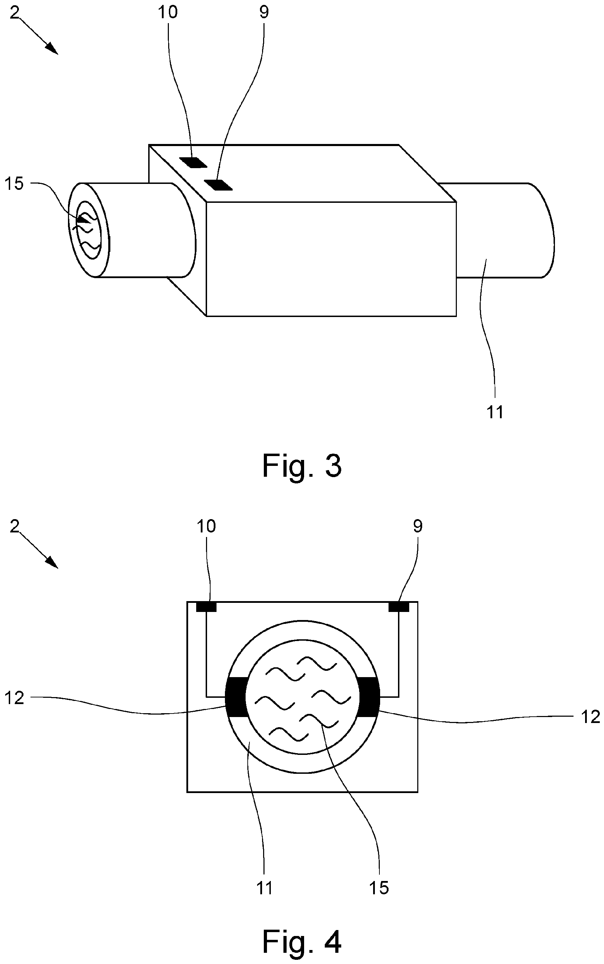

Die Figuren 1 bis 4 zeigen ein Ausführungsbeispiel eines modularen magnetisch-induktiven Durchflussmessgeräts 1. Das modulare magnetisch-induktive Durchflussmessgerät 1 ist einmal in einer perspektivischen Seitenansicht, siehe Figur 1, und einmal in einer geschnittenen Seitenansicht, siehe Figur 2, ohne das in den Figuren 3 und 4 dargestellte Ausführungsbeispiel eines dazugehörigen Messmoduls 2 dargestellt. Figur 3 zeigt das Messmodul 2 in einer perspektivischen Seitenansicht und Figur 4 in einer geschnittenen Seitenansicht.

Das modulare magnetisch-induktive Durchflussmessgerät 1 weist eine Spule 3, eine Steuerung 4 und eine Messmodulaufnahme 5 für das Messmodul 2 auf. Die Messmodulaufnahme 5 weist einen ersten Anschluss 6 und einen zweiten Anschluss 7 auf. Der erste Anschluss 6 und der zweite Anschluss 7 sind jeweils über eine Messleitung 8 mit der Steuerung 4 verbunden.

Das Messmodul 2 weist einen ersten Anschluss 9, einen zweiten Anschluss 10 und ein Messrohr 11 mit zwei Elektronen 12 auf.

Durch ein Einsetzen des Messmoduls 2 in die Messmodulaufnahme 5 sind zum einen die ersten Anschlüsse 6, 9 und zum anderen die zweiten Anschlüsse 7, 10 jeweils miteinander verbindbar.

Bei eingesetztem Messmodul 2 ist die Spule 3 zusammen mit einem Joch 13 zur Erzeugung eines Magnetfelds 14 in einem Medium 15 im Messrohr 11 ausgebildet. Die Messelektroden 12 sind zum Abgreifen einer durch ein Strömen des Mediums 15 im Magnetfeld 14 erzeugten Messspannung im Medium 15 ausgebildet. Die Steuerung 4 ist zur Bestimmung eines Durchflusses des Mediums 15 unter Verwendung der über die ersten Anschlüsse 6, 9 und der zweiten Anschlüsse 7, 10 und die Messleitungen 8 übertragenen Messspannung ausgebildet.

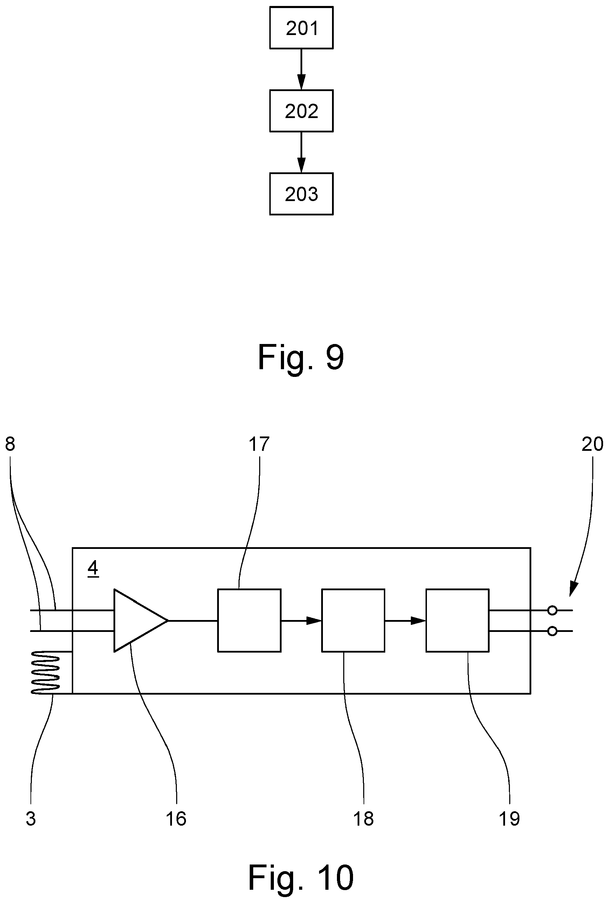

Figur 10 zeigt ein Blockschaltbild der Steuerung 4. Die Steuerung 4 weist als Komponenten die Messleitungen 8, einen Verstärker 16 zur Verstärkung der Messspannung, einen Analog-Digital-Umsetzer 17 zur Digitalisierung der verstärkten Messspannung, eine Recheneinheit 18 zur Bestimmung des Durchflusses des Mediums 15 unter Verwendung der digitalisierten Messspannung und eine Schnittstelle 19 zur Ausgabe des bestimmten Durchflusses auf. In diesem Ausführungsbeispiel ist die Schnittstelle 19 als Stromschleifenschnittstelle ausgefüllt. Die Schnittstelle 19 ist mit einer Stromschleife 20 verbunden. Das modulare magnetisch-induktive Durchflussmessgerät 1 wird aus der Stromschleife 20 auch mit elektrischer Energie versorgt.

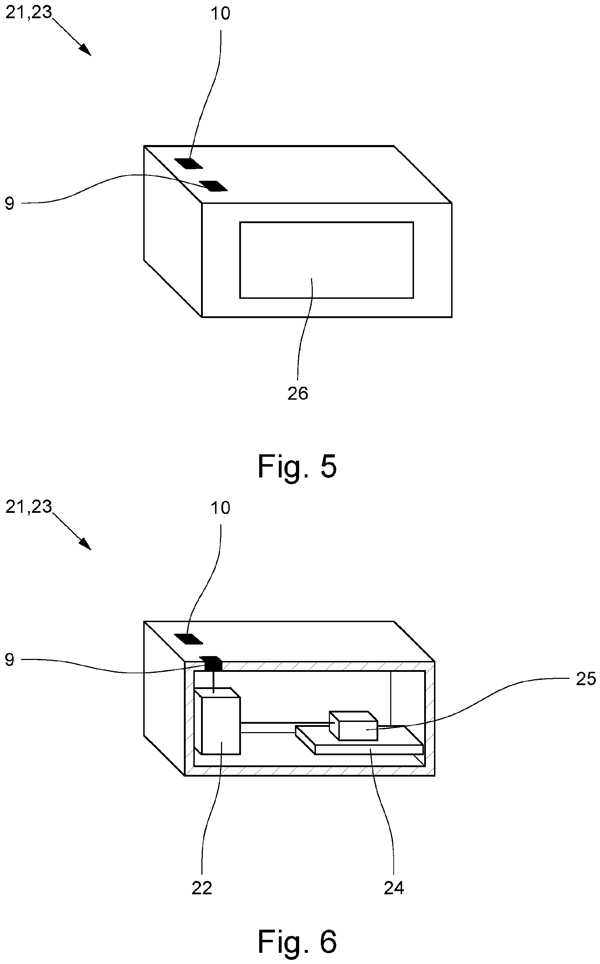

Die Figuren 5 und 6 zeigen ein Ausführungsbeispiel einer Testvorrichtung 21 für das modulare magnetisch-induktive Durchflussmessgerät 1, und zwar einmal in einer perspektivischen Seitenansicht, siehe Figur 5, und einmal in einer geschnittenen Seitenansicht, siehe Figur 6.

Die Testvorrichtung 21 weist eine Teststeuerung 22 und ein Testmessmodul 23 für die Messmodulaufnahme 5 auf. In diesem Ausführungsbeispiel ist die Testvorrichtung 21 vollständig in das Testmessmodul 23 integriert. Das Testmessmodul 23 weist eine Halterung 24 mit einem Magnetfeldsensor 25, einen ersten Anschluss 9, einen zweiten Anschluss 10 und eine Anzeige 26 auf. Der erste Anschluss 9 und der zweite Anschluss 10 sind jeweils mit der Teststeuerung 22 verbunden. Die Anschlüsse 9, 10 des Testmessmoduls 23 sind identisch ausgebildet zu den Anschlüssen 9, 10 des Messmoduls 2. Durch ein Einsetzen des Testmessmoduls 23 sind zum einen die ersten Anschlüsse 6, 9 und zum anderen die zweiten Anschlüsse 7, 10 jeweils miteinander verbindbar. Das Testmessmodul 23 ist werkzeuglos und beschädigungsfrei manuell einsetzbar in die, entnehmbar aus der und befestigbar in der Modulaufnahme 5 des modularen magnetisch-induktiven Durchflussmessgeräts 1.

Die Teststeuerung 22 ist zum Einspeisen einer Testspannung zwischen dem ersten Anschluss 9 und dem zweiten Anschluss 10 des Testmessmoduls 23 ausgebildet. In der Teststeuerung 22 ist mindestens ein Sollwert einer Stärke des Magnetfelds 14 als eine Größe des Magnetfelds 14 abgespeichert. Sie ist ausgebildet, bei eingesetztem Testmessmodul 23 unter Verwendung des Magnetfeldsensors 25 mindestens einen Istwert der Stärke des Magnetfelds 14 zu messen. Weiter ist die Teststeuerung 22 ausgebildet, eine Abweichung des mindestens einen Istwerts von dem mindestens einen Sollwert zu bestimmen und auf der Anzeige 26 anzuzeigen.

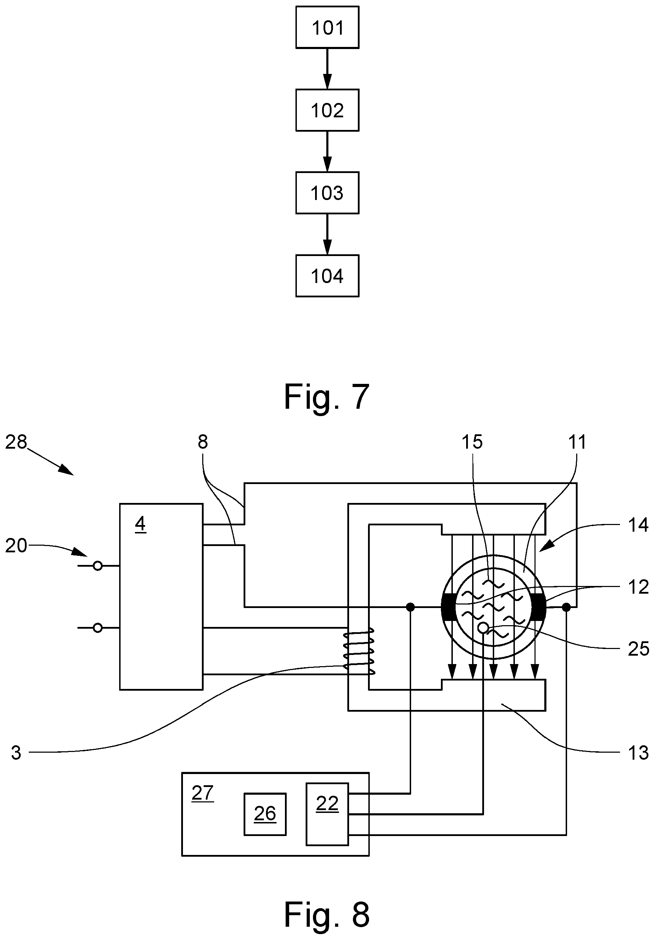

Figur 7 zeigt einen Ablaufplan eines Ausführungsbeispiels eines Testverfahrens für die Testvorrichtung 21 für das modulare magnetisch-induktive Durchflussmessgerät 1. Und zwar werden im Betrieb sowohl des modularen magnetisch-induktiven Durchflussmessgeräts 1 als auch der Testvorrichtung 21 die folgenden Verfahrensschritte ausgeführt.

In einem ersten Verfahrensschritt 101 wird von der Teststeuerung 22 mindestens ein Sollwert mindestens einer Größe des Magnetfelds 14 abgespeichert.

In einem zweiten Verfahrensschritt 102 wird das Testmessmodul 23 in die Messmodulaufnahme 5 des modularen magnetisch-induktiven Durchflussmessgeräts 1 eingesetzt.

In einem dritten Verfahrensschritt 103 wird dann von der Spule 3, welche durch die Steuerung 4 gesteuert wird, das Magnetfeld 14 erzeugt und wird von der Teststeuerung 22 unter Verwendung des Magnetfeldsensors 25 mindestens ein Istwert der Stärke des Magnetfelds 14 gemessen.

In einem vierten Verfahrensschritt 104 wird von der Teststeuerung 22 eine Abweichung des mindestens einen Istwerts von dem mindestens einen Sollwert bestimmt und auf der Anzeige 26 angezeigt.

Figur 8 zeigt ein Ausführungsbeispiel einer Testvorrichtung 27 für ein monolithisches magnetisch-induktives Durchflussmessgerät 28 und ein solches in einer Vorderansicht.

Das monolithische magnetisch-induktive Durchflussmessgerät 28 weist eine Spule 3, ein Joch 13, eine Steuerung 4 und ein Messrohr 11 mit zwei Messelektroden 12 auf. Jede der Messelektroden 12 ist über jeweils eine Messleitung 8 mit der Steuerung 4 verbunden. Die Spule 3 ist in Verbindung mit dem Joch 13 zur Erzeugung eines Magnetfelds 14 in einem Medium 15 im Messrohr 11 ausgebildet. Die Messelektroden 12 sind zum Abgreifen einer durch ein Strömen des Mediums 15 im Magnetfeld 14 erzeugten Messspannung im Medium 15 ausgebildet. Die Steuerung 4 ist zur Bestimmung eines Durchflusses des Mediums 15 unter Verwendung der über die Messleitungen 8 übertragenen Messspannung ausgebildet.

Die Testvorrichtung 27 weist eine Teststeuerung 22 und einen Magnetfeldsensor 25 auf. Die Testvorrichtung 27 ist zur Anordnung des Magnetfeldsensors 25 im Magnetfeld 14 ausgebildet, hier sogar im Messrohr 11. Weiter ist in der Teststeuerung 22 mindestens ein Sollwert mindestens einer Größe des Magnetfelds 14 abgespeichert. Die Teststeuerung 22 ist unter Verwendung des Magnetfeldsensors 25 zum Messen mindestens eines Istwerts der Stärke des Magnetfelds 14 ausgebildet. Die Teststeuerung 22 ist weiter zum Bestimmen einer Abweichung des mindestens einen Istwerts von dem mindestens einen Sollwert und zur Anzeige der Abweichung auf der Anzeige 26 ausgebildet.

Die Testvorrichtung 27 ist derart ausgebildet, sodass die Teststeuerung 22 mit den Messelektroden 12 reversibel und beschädigungsfrei verbindbar ist. Weiter ist die Teststeuerung 22 zum Einspeisen einer Testspannung zwischen den Messelektroden 12 ausgebildet.

Im Übrigen gelten für die Testvorrichtung 27 für das monolithische magnetisch-induktive Durchflussmessgerät 28 die Ausführungen zur Testvorrichtung 21 für das modulare magnetisch-induktive Durchflussmessgerät 1 entsprechend.

Figur 9 zeigt einen Ablaufplan eines Ausführungsbeispiels eines Testverfahrens für die Testvorrichtung 27 für das monolithische magnetisch-induktive Durchflussmessgerät 28. Und zwar werden im Betrieb sowohl des monolithischen magnetisch-induktiven Durchflussmessgeräts 28 als auch der Testvorrichtung 27 die folgenden Verfahrensschritte ausgeführt.

In einem ersten Verfahrensschritt 201 wird von der Teststeuerung 22 mindestens ein Sollwert mindestens einer Größe des Magnetfelds 14 abgespeichert.

In einem zweiten Verfahrensschritt 202 wird dann von der Spule 3, welche durch die Steuerung 4 gesteuert wird, das Magnetfeld 14 erzeugt und wird von der Teststeuerung 22 unter Verwendung des Magnetfeldsensors 25 mindestens ein Istwert der Stärke des Magnetfelds 14 gemessen.

In einem dritten Verfahrensschritt wird von der Teststeuerung 22 eine Abweichung des mindestens einen Istwerts von dem mindestens einen Sollwert bestimmt und auf der Anzeige 26 angezeigt.

Figur 10 zeigt ein Blockschaltbild der Steuerung 4 des monolithischen magnetisch-induktiven Durchflussmessgeräts 28. Sie ist ausgebildet wie die des modularen magnetisch-induktiven Durchflussmessgeräts 1.

Die Ausführungen zum Ausführungsbeispiel der Testvorrichtung 21 für das modulare magnetisch-induktive Durchflussmessgerät 1 gelten entsprechend für die Testvorrichtung 27 für das monolithische magnetisch-induktive Durchflussmessgerät 28 und umgekehrt. Gleiches gilt für das modulare magnetisch-induktive Durchflussmessgerät 1 und das das monolithische magnetisch-induktive Durchflussmessgerät 28.

### Bezugszeichen

- 1: modulares magnetisch-induktives Durchflussmessgerät
- 2: Messmodul
- 3: Spule
- 4: Steuerung
- 5: Messmodulaufnahme
- 6: erster Anschluss des modularen magnetisch-induktiven Durchflussmessgeräts
- 7: zweiter Anschluss des modularen magnetisch-induktiven Durchflussmessgeräts
- 8: Messleitung
- 9: erster Anschluss des Messmoduls bzw. des Testmessmoduls
- 10: zweiter Anschluss des Messmoduls bzw. des Tesmessmoduls
- 11: Messrohr
- 12: Messelektrode
- 13: Joch
- 14: Magnetfeld
- 15: Medium
- 16: Verstärker
- 17: Analog-Digital-Umsetzer
- 18: Recheneinheit
- 19: Schnittstelle
- 20: Stromschleife
- 21: Testvorrichtung für das modulare magnetisch-induktive Durchflussmessgerät
- 22: Teststeuerung
- 23: Testmessmodul
- 24: Halterung
- 25: Magnetfeldsensor
- 26: Anzeige
- 27: Testvorrichtung für das monolithische magnetisch-induktive Durchflussmessgerät
- 28: monolithisches magnetisch-induktives Durchflussmessgerät

## Patentansprüche

1. Testvorrichtung (21) für ein modulares magnetisch-induktives Durchflussmessgerät (1),
wobei das zu testende modulare magnetisch-induktive Durchflussmessgerät (1) eine Spule (3), eine Steuerung (4) und eine Messmodulaufnahme (5) für ein Messmodul (2) aufweist,
wobei die Messmodulaufnahme (5) einen ersten Anschluss (6) und einen zweiten Anschluss (7) aufweist und der erste Anschluss (6) und der zweite Anschluss (7) jeweils über eine Messleitung (8) mit der Steuerung (4) verbunden sind,
wobei das Messmodul (2) einen ersten Anschluss (9), einen zweiten Anschluss (10) und ein Messrohr (11) mit zwei Messelektroden (12) aufweist,
wobei durch ein Einsetzen des Messmoduls (2) in die Messmodulaufnahme (5) zum einen die ersten Anschlüsse (6, 9) und zum anderen die zweiten Anschlüsse (7, 10) jeweils miteinander verbindbar sind,
wobei bei eingesetztem Messmodul (2) die Spule (3) zur Erzeugung eines Magnetfelds (14) in einem Medium (15) im Messrohr (11) ausgebildet ist, die Messelektroden (12) zum Abgreifen einer durch ein Strömen des Mediums (15) im Magnetfeld (14) erzeugten Messspannung im Medium (15) ausgebildet sind und die Steuerung (4) zur Bestimmung eines Durchflusses des Mediums (15) unter Verwendung der über die ersten Anschlüsse (6, 9) und zweiten Anschlüsse (7, 10) und die Messleitungen (8) übertragenen Messspannung ausgebildet ist,
**dadurch gekennzeichnet,**
**dass** die Testvorrichtung (21) eine Teststeuerung (22) und ein Testmessmodul (23) für die Messmodulaufnahme (5) aufweist,
**dass** das Testmessmodul (23) eine Halterung (24) mit einem Magnetfeldsensor (25) aufweist,
**dass** in der Teststeuerung (22) mindestens ein Sollwert mindestens einer Grö-ße des Magnetfelds (14) abgespeichert ist und
**dass** die Teststeuerung (22) bei eingesetztem Testmessmodul (23) unter Verwendung des Magnetfeldsensors (25) zum Messen mindestens eines Istwerts der mindestens einen Größe des Magnetfelds (14) und zum Bestimmen einer Abweichung des mindestens einen Istwerts von dem mindestens einen Sollwert und zur Anzeige der Abweichung ausgebildet ist.

2. Testvorrichtung (21) nach Anspruch 1, **dadurch gekennzeichnet,**
**dass** das Testmessmodul (23) einen ersten Anschluss (9) und einen zweiten Anschluss (10) aufweist und der erste Anschluss (9) und der zweite Anschluss (10) jeweils mit der Teststeuerung (22) verbunden sind,
**dass** durch ein Einsetzen des Testmessmoduls (23) zum einen die ersten Anschlüsse (6, 9) und zum anderen die zweiten Anschlüsse (7, 10) jeweils miteinander verbindbar sind und
**dass** die Teststeuerung (22) zum Einspeisen einer Testspannung zwischen dem ersten Anschluss (7) und dem zweiten Anschluss (10) ausgebildet ist.

3. Testvorrichtung (21) nach Anspruch 1 oder 2, **dadurch gekennzeichnet, dass** das Testmessmodul (23) werkzeuglos und beschädigungsfrei manuell einsetzbar in die, entnehmbar aus der und befestigbar in der Modulaufnahme (5) ist.

4. Testvorrichtung (21) nach einem der Ansprüche 1 bis 3, **dadurch gekennzeichnet, dass** die Halterung (24) ein Messrohr (11) ist.

5. Testvorrichtung (27) für ein monolithisches magnetisch-induktives Durchflussmessgerät (28),
wobei das zu testende monolithische magnetisch-induktive Durchflussmessgerät (28) eine Spule (3), eine Steuerung (4) und ein Messrohr (11) mit zwei Messelektroden (12) aufweist,
wobei jede der Messelektroden (12) über jeweils eine Messleitung (8) mit der Steuerung (4) verbunden ist,
wobei die Spule (3) zur Erzeugung eines Magnetfelds (14) in einem Medium (15) im Messrohr (11) ausgebildet ist, die Messelektroden (12) zum Abgreifen einer durch ein Strömen des Mediums (15) im Magnetfeld (14) erzeugten Messspannung im Medium (15) ausgebildet sind und die Steuerung (4) zur Bestimmung eines Durchflusses des Mediums (15) unter Verwendung der über die Messleitungen (8) übertragenen Messspannung ausgebildet ist,
**dadurch gekennzeichnet,**
**dass** die Testvorrichtung (27) eine Teststeuerung (22) und einen Magnetfeldsensor (25) aufweist,
**dass** die Testvorrichtung (27) zur Anordnung des Magnetfeldsensors (25) im Magnetfeld (14) ausgebildet ist,
**dass** in der Teststeuerung (22) mindestens ein Sollwert mindestens einer Grö-ße des Magnetfelds (14) abgespeichert ist,
**dass** die Teststeuerung (22) unter Verwendung des Magnetfeldsensors (25) zum Messen mindestens eines Istwerts der mindestens einen Größe des Magnetfelds (14), zum Bestimmen einer Abweichung des mindestens einen Istwerts von dem mindestens einen Sollwert und zur Anzeige der Abweichung ausgebildet ist.

6. Testvorrichtung (27) nach Anspruch 5, **dadurch gekennzeichnet, dass** die Teststeuerung (22) mit den Messelektroden (12) reversibel und beschädigungsfrei verbindbar ist und dass die Teststeuerung (22) zum Einspeisen einer Testspannung zwischen dem ersten Anschluss (9) und dem zweiten Anschluss (10) ausgebildet ist.

7. Testvorrichtung (27) nach einem der Ansprüche 1 bis 6, **dadurch gekennzeichnet, dass** die mindestens Größe des Magnetfelds (14) eine Stärke und/oder eine Frequenz und/oder eine Einschwingzeit des Magnetfelds (14) ist.

8. Testvorrichtung (21, 27) nach Anspruch 2 oder 6, **dadurch gekennzeichnet, dass** die Größe eine Stärke des Magnetfelds (14) ist, dass die Teststeuerung (22) ausgebildet ist, einen Istwert der Stärke des Magnetfelds (14) zu messen, zu einem Sollwert eines Durchflusses unter Verwendung des Istwerts der Stärke des Magnetfelds (14) einen Sollwert für die Messspannung zu bestimmen, die Testspannung mit dem Sollwert zu erzeugen, einen von der Steuerung (4) bestimmten Istwert des Durchflusses aus der Steuerung (4) auszulesen, eine Abweichung des Istwerts vom Sollwert zu bestimmen und die Abweichung anzuzeigen.

9. Testvorrichtung (21, 27) nach Anspruch 8, **dadurch gekennzeichnet, dass** die Steuerung (4) als Komponenten die Messleitungen (8), einen Verstärker (16) zur Verstärkung der Messspannung, einen Analog-Digital-Umsetzer (17) zur Digitalisierung der verstärkten Messspannung, eine Recheneinheit (18) zur Bestimmung des Durchflusses des Mediums unter Verwendung der digitalisierten Messspannung und eine Schnittstelle (19) zur Ausgabe des bestimmten Durchflusses aufweist und dass die Teststeuerung (22) zur Überprüfung von zumindest einer der Komponenten unter Verwendung der Abweichung ausgebildet ist.

10. Testvorrichtung (21, 27) nach einem der Ansprüche 1 bis 8, **dadurch gekennzeichnet, dass** der mindestens eine Sollwert ein zuvor gemessener Istwert ist, sodass die Abweichung ein Maß für eine Reproduzierbarkeit ist.

11. Testvorrichtung (21, 27) nach einem der Ansprüche 1 bis 10, **dadurch gekennzeichnet, dass** die Testvorrichtung (21, 27) einen Energiespeicher aufweist und die Testvorrichtung (21, 27) zur Versorgung mit Energie aus dem Energiespeicher ausgebildet ist.

12. Testvorrichtung (21, 27) nach einem der Ansprüche 1 bis 11, **dadurch gekennzeichnet, dass** die Testvorrichtung (21, 27) zur Versorgung durch ein magnetisch-induktives Durchflussmessgerät (1, 28) ausgebildet ist.

13. Testvorrichtung (21, 27) nach einem der Ansprüche 1 bis 12, **dadurch gekennzeichnet, dass** der Magnetfeldsensor (25) ein Hall-Sensor ist.

14. Testverfahren für eine Testvorrichtung (21) für ein modulares magnetisch-induktives Durchflussmessgerät (1),
wobei das zu testende modulare magnetisch-induktive Durchflussmessgerät (1) eine Spule (3), eine Steuerung (4) und eine Messmodulaufnahme (5) für ein Messmodul (2) aufweist,
wobei die Messmodulaufnahme (5) einen ersten Anschluss (6) und einen zweiten Anschluss (7) aufweist und der erste Anschluss (6) und der zweite Anschluss (7) jeweils über eine Messleitung (8) mit der Steuerung (4) verbunden sind,
wobei das Messmodul (2) einen ersten Anschluss (9), einen zweiten Anschluss (10) und ein Messrohr (11) mit zwei Messelektroden (12) aufweist,
wobei durch ein Einsetzen des Messmoduls (2) in die Messmodulaufnahme (5) zum einen die ersten Anschlüsse (6, 9) und zum anderen die zweiten Anschlüsse (7, 10) jeweils miteinander verbindbar sind,
wobei bei eingesetztem Messmodul (2) die Spule (3) zur Erzeugung eines Magnetfelds (14) in einem Medium (15) im Messrohr (11) ausgebildet ist, die Messelektroden (12) zum Abgreifen einer durch ein Strömen des Mediums (15) im Magnetfeld (14) erzeugten Messspannung im Medium (15) ausgebildet sind und die Steuerung (4) zur Bestimmung eines Durchflusses des Mediums (15) unter Verwendung der über die ersten Anschlüsse (6, 9) und zweiten Anschlüsse (7, 10) und die Messleitungen (8) übertragenen Messspannung ausgebildet ist,
wobei die Testvorrichtung (21) eine Teststeuerung (22) und ein Testmessmodul (23) für die Messmodulaufnahme (5) aufweist,
wobei das Testmessmodul (23) eine Halterung (24) mit einem Magnetfeldsensor (25) aufweist,
wobei von der Teststeuerung (22) mindestens ein Sollwert mindestens einer Größe des Magnetfelds (14) abgespeichert wird,
wobei das Testmessmodul (23) eingesetzt wird,
wobei dann von der Spule (3) das Magnetfeld (14) erzeugt und von der Teststeuerung (22) unter Verwendung des Magnetfeldsensors (25) mindestens ein Istwert der mindestens einen Größe des Magnetfelds (14) gemessen und eine Abweichung des mindestens einen Istwerts von dem mindestens einen Sollwert bestimmt und angezeigt wird.

15. Testverfahren nach Anspruch 14, wobei die Testvorrichtung (21) nach einem der Ansprüche 2 bis 4 oder 7 bis 13 ausgebildet ist.

16. Testverfahren für eine Testvorrichtung (27) für ein monolithisches magnetisch-induktives Durchflussmessgerät (28),
wobei das zu testende monolithische magnetisch-induktive Durchflussmessgerät (28) eine Spule (3), eine Steuerung (4) und ein Messrohr (11) mit zwei Messelektroden (12) aufweist,
wobei jede der Messelektroden (12) über jeweils eine Messleitung (8) mit der Steuerung (4) verbunden ist,
wobei die Spule (3) zur Erzeugung eines Magnetfelds (14) in einem Medium (15) im Messrohr (11) ausgebildet ist, die Messelektroden (12) zum Abgreifen einer durch ein Strömen des Mediums (15) im Magnetfeld (14) erzeugten Messspannung im Medium (15) ausgebildet sind und die Steuerung (4) zur Bestimmung eines Durchflusses des Mediums (15) unter Verwendung der über die Messleitungen (8) übertragenen Messspannung ausgebildet ist,
wobei die Testvorrichtung (27) eine Teststeuerung (22) und einen Magnetfeldsensor (25) aufweist,
wobei die Teststeuerung (22) zur Anordnung des Magnetfeldsensors (25) im Magnetfeld (14) ausgebildet ist,
wobei von der Teststeuerung (22) mindestens ein Sollwert mindestens einer Größe des Magnetfelds (14) abgespeichert wird,
wobei dann von der Spule (3) das Magnetfeld (14) erzeugt und von der Teststeuerung (22) unter Verwendung des Magnetfeldsensors (25) mindestens ein Istwert der mindestens einen Größe des Magnetfelds (14) gemessen und eine Abweichung des mindestens einen Istwerts von dem mindestens einen Sollwert bestimmt und angezeigt wird.

17. Testverfahren nach Anspruch 16, wobei die Testvorrichtung (27) nach einem der Ansprüche 5 bis 13 ausgebildet ist.

18. Testverfahren nach einem der Ansprüche 14 bis 17, wobei ein Trocken-Kalibrierverfahren unter Verwendung der Abweichung ausgeführt wird.
